# EUROPEAN PATENT SPECIFICATION

(11) **EP 3 179 574 B1**
(45) Date of publication and mention of the grant of the patent: **18.09.2019**
(21) Application number: 16202316.2
(22) Date of filing: 06.12.2016
(51) Int. Cl.: H01R 13/66, H03H 1/00, H01R 13/7197, H01R 103/00, H01R 13/7193, H01F 17/06, H01R 13/53

(54) **HIGH-VOLTAGE CONNECTOR ARRANGEMENT**
HOCHSPANNUNGSSTECKVERBINDER ANORDNUNG
ASSEMBLAGE DE CONNECTEURS HAUTE TENSION

(30) Priority: 10.12.2015 DE 102015224872
(43) Date of publication of application: 14.06.2017
(73) Proprietor: TE Connectivity Germany GmbH, 64625 Bensheim (DE)
(72) Inventor: CHRITZ, Gunther, 69488 Birkenau (DE)
(74) Representative: Grünecker Patent- und Rechtsanwälte PartG mbB

(56) References cited:
- EP-A1- 2 911 295
- WO-A2-2004/004071
- DE-A1-102013 101 323
- US-A1- 2015 289 420

## Description

The present invention relates to a high-voltage connector arrangement. Mastering electromagnetic compatibility (EMC) is increasingly becoming a key in the development of electrical motor vehicle propulsion concepts. Since the power requirements of the electrical propulsion chain cannot be covered via conventional low-voltage vehicle electric systems (LV) with a supply voltage of 12 VDC, a traction vehicle electric system is introduced, the voltage level of which is typically in the range of 120 to 1000 VDC. This high-voltage (HV) vehicle electric system connects the energy store which is usually placed underneath the luggage space in the rear of the vehicle to the power converter and a synchronous machine in the engine compartment. Since the semiconductor components in the pulse inverter switch with maximally fast clock edges in order to minimise thermal losses, interference pulses with high amplitudes are created which contain high-frequency (HF) spectral components. These can disrupt adjacent electronic systems. The increasing number of sensitive radio services, such as VHF radio, GPS navigation, mobile telephony or driver assistance systems, additionally exacerbates the situation. Systems outside of the vehicle must also not be disrupted. This is regulated in international standards such as CISPR 25 or EU Guideline ECE-R10.

In order to improve the EMC of the electrical propulsion, it is known to design the HV vehicle electrical system to be completely shielded. In this case, individually shielded coaxial cables which in the HF range behave like waveguides are used. These cables perform an impedance transformation of its line termination and mismatching at the cable ends can lead to reflected disturbance variables and resonance magnifications due to standing waves on the line.

To connect the inverter to the battery, a suitably long shielded cable is required which can, however, endanger the safeguarding of the EMC. On the one hand, high shield currents can occur which, if they are in the high-frequency range, contribute to high emissions, and voltage peaks which can even lead to damaging of the inverter or battery if of a suitable size. Furthermore, disruptions can be coupled into the vehicle's low-voltage system. A further problem is the electrical and mechanical connection of the cable shield to the shielding of the battery or inverter. The impedance of this connection must be extremely low in order to ensure sufficient shielding. Especially in vehicles, there arise, through vibration or shock, mechanical forces which weaken the shield connection and thus allow the impedance to grow over the long term. Ageing processes, which also arise through oxidation or corrosion, should also not be ignored.

The provision of EMC filter arrangements between the battery and the inverter is therefore known. These EMC filters are typically two-wire HV direct current filters which filter out the HF portions in the direct current output and thus reduce the disturbance emissions linked to the line.

Furthermore, through the steep switching edges, voltage peaks occur which are further elevated through line inductances. In order to prevent the leakage current which results from this, it is known to employ ferrite ring cores, through which the lines are guided.

Such a filter arrangement having several ferrite ring cores is known from DE 10 2013 101 323 A1. A filter component according to this publication comprises a housing body, a first and at least one second bus bar which respectively have a first end section and a second end section, between which there is arranged a middle section in each case. The end sections of the at least two bus bars respectively have terminals for linking electrical conductors to the filter component. The first and second end sections and the middle section of the first bus bar are arranged in a first plane and the first and second end sections and the middle section of the at least one second bus bar are arranged in a second plane which is different from the first plane. As a result, the known filter component can be connected to the electrical conductors from one mounting direction.

However, the provision of EMC filter arrangements and ring cores at the terminal panels of the battery take up valuable installation space in the motor vehicle. Furthermore, costly connection techniques are required, which make installation more expensive and increase subsequent maintenance costs.

WO 2004/004071 A2 discloses a filter assembly for filtering of electrical signals, and to a filtered electrical connector including such a filter assembly, e. g. for connecting vehicle control electronics with the igniter of an airbag device. In particular, this document relates to a filtered electrical connector with adjustable performance using combined multi-aperture ferrite cores. The document also relates to a filter assembly for filtering of electrical signals, and to a filtered electrical connector including such a filter assembly, in particular, to a filtered electrical connector with ferrite block combinations for different signal mode filtering (differential mode, common mode).

US 2015/0289420 A1 relates to a wiring member. According to this document, a wire harness includes first to third electric wires, a braid shield that covers the first to third electric wires, and a tube-shaped electromagnetic wave absorber having a through hole that allows the first to third electric wires to be inserted therethrough, the electromagnetic wave absorber absorbing electromagnetic waves emitted from the first to third electric wires. The braid shield covers an outer circumferential surface and two axial end surfaces of the electromagnetic wave absorber to restrict movement of the electromagnetic wave absorber in an axial direction. The braid shield satisfies 1≦n≦15 and 10≦m≦50 where the number of carriers of the braid shield is denoted by n and the number of ends of the braid shield is denoted by m.

EP 2911295 A1 relates to an electromagnetic interference filter assembly. In particular, an assembly and method for providing electromagnetic interference isolation are disclosed. The assembly includes an enclosure which has a first panel and a second panel. Bus bars extend through the first panel and the second panel. A mounting plate is positioned between the first panel and the second panel. The mounting plate has locating members thereon. A plurality of inductive cores are positioned proximate the locating members, the inductive cores having openings through which the bus bars extend. The inductive cores are precisely positioned in the enclosure to facilitate the electromagnetic interference isolation. The assembly may comprise a circuit board, capacitors mounted on the circuit board, and conductive members extending between and electrically connecting the circuit board and the bus bars. The assembly may comprise tabs extending from a surface of the mounting plate, pairs of tabs forming respective cradles into which the inductive cores are positioned.

There is still a need for improved filter arrangements which can be produced in a space-saving and reliable, but also cost-effective, manner.

This problem is solved by the subject-matter of the independent claim 1. Advantageous embodiments of the present invention are the subject of the dependent claims.

In this case, the present invention is based on the idea that the current-carrying elements of an EMC filter arrangement are guided perpendicularly through a round magnetic core and are introduced directly into the plug interface lying thereunder. The components of the filter arrangement are thus part of a high-voltage plug interface. In particular, a filter assembly for a high-voltage connector arrangement has a first and at least one second electrically conductive bus bar. Each bus bar respectively has a first terminal section which can be connected to a first connector element, and a second terminal section which can be connected to a second connector element, and a connecting section which is arranged between the first and second terminal sections. The filter assembly has a filter circuit which is arranged on a circuit carrier, at least one ring core element and a filter housing which encompasses the filter circuit, the ring core element, and respectively at least a part of the first and at least one second electrically conductive bus bars. The first and at least one second bus bar run substantially parallel to each other and go through the at least one ring core element, the circuit carrier with the filter circuit being arranged in a region of the filter housing in which the connecting sections of the bus bars are accommodated. The circuit carrier can in this case be arranged along the bus bars outside or inside the ring core element. Alternatively, the circuit carrier can also be arranged substantially at right angles to the connecting sections of the bus bars (and thus parallel to the ring core element). The circuit carrier can furthermore also be designed in multiple pieces and/or flexibly.

Such an integrated filter arrangement has the advantage that the HV EMC filtering is carried out with extremely small installation space requirements. Furthermore, electrical connections, for example screw connections, can be omitted. The ability to be mounted is simplified and the arrangement possesses a high current-carrying capacity and reduced development of heat. Simple tools may be used for mounting.

For the filter arrangement, conventional standard magnetic cores are used as a ring core element. For example, the ring core element can be produced from a magnetic material, preferably ferrite. For example, the at least one ring core element has the geometry of a torus, the middle axis of which runs along the connecting sections of the bus bars. This represents a conventional geometry which can be produced simply and which is also particularly effective. However, it is clear to a person skilled in the art that other forms, preferably symmetrical with regard to a longitudinal middle axis, can also be used. Furthermore, according to the present invention, it is also possible for several ring core elements to be integrated in the filter arrangement.

According to the invention, the second terminal sections are configured as plug contact elements which are part of the second connector element and which can be connected to associated mating plug contacts. In this manner, the bus bars can function directly as part of the connector element and additional electrical connections and transfer resistances can be dispensed with.

Filtering which is particularly stable and efficient in mechanical and electrical terms can be achieved if the terminal sections configured as plug contact elements emerge as a rectilinear prolongation from the connecting sections.

Furthermore, the filter housing has a housing base element in which the bus bars and circuit carrier are held, and a housing cover element which is fixed to the housing base element for closing the filter housing. This arrangement can be constructed particularly easily and enables the modular production of larger units such as high-voltage connector arrangements which are used in so-called Battery Disconnect Units (BDU), for example. In particular, the housing base element and the housing cover element can be interlocked with one another. However, other connection techniques, such as ultrasound welding or gluing may alternatively also be used.

In order to electrically contact the filter circuit, according to the present invention, terminals are guided outwards. In this manner, it is possible to simply produce the connections to further filter modules or to external components, for example.

The present disclosure furthermore relates to an associated high-voltage connector arrangement with at least one first connector element for contacting a power source and at least one second connector element for contacting a consumer, furthermore comprising at least one filter assembly according to the present invention, wherein the first and second connector elements are connected to one another by the at least one filter assembly. Such a high-voltage connector arrangement is used in HV terminal panels of the battery. Through this integrated arrangement, efficient EMC filtering can be achieved alongside minimal installation space requirements.

A, in mechanical terms, particularly secure connection to the connector element at the battery can be achieved by the first terminal section of the at least two bus bars being respectively connected, by means of a screw connection, to the connector element, which is designed as a plug connector, in order to contact the power source. Those second terminal sections of the at least two bus bars which are respectively opposite the first terminal sections can advantageously be configured as plug contact elements which are directly part of the second connector element. Thus additional plug contacts no longer have to be mounted for the second connector element. As a result, the mounting outlay is reduced, the transfer resistance is kept low and the reliability is increased.

If several lines are meant to be connected, the high-voltage connector arrangement according to the present invention can also comprise a plurality of filter assemblies.

In this case, each of the filter assemblies can be constructed separately and be made available as a module. Advantageously, each of the filter assemblies has a separate filter housing for this. However, it is obviously also possible to produce the filter assemblies with an integrated common filter housing.

In the connector housing of the high-voltage connector arrangement, a preferably metallic shielding is additionally provided which is arranged such that it at least partly surrounds the filter assemblies. In this manner, EMC disturbance variables can be eliminated particularly efficiently.

In order to prevent the ingress of moisture and dirt, the first and/or the second connector element can be designed such that it hermetically seals the at least one filter assembly. In this manner, the appearance of corrosion can be reduced as much as possible.

To better understand the present disclosure, this is explained in greater detail using the exemplary embodiments depicted in the following figures. Identical parts are hereby provided with identical reference numbers and identical component names. Furthermore, some features or combinations of features from the various embodiments shown and described may also represent independent solutions, inventive solutions or solutions according to the invention. In the drawings:
**Fig. 1** shows a perspective depiction of a filter assembly for a high-voltage connector arrangement;
**Fig. 2** shows a partly exploded perspective depiction of the filter assembly from Figure 1;
**Fig. 3** shows a partly exploded perspective depiction of a high-voltage connector arrangement with two filter assemblies according to the present invention;
**Fig. 4** shows a partly exploded perspective depiction of a part of the arrangement from Figure 3;
**Fig. 5** shows a sectional depiction of that part of the arrangement from Figure 3 which is shown in Figure 4.

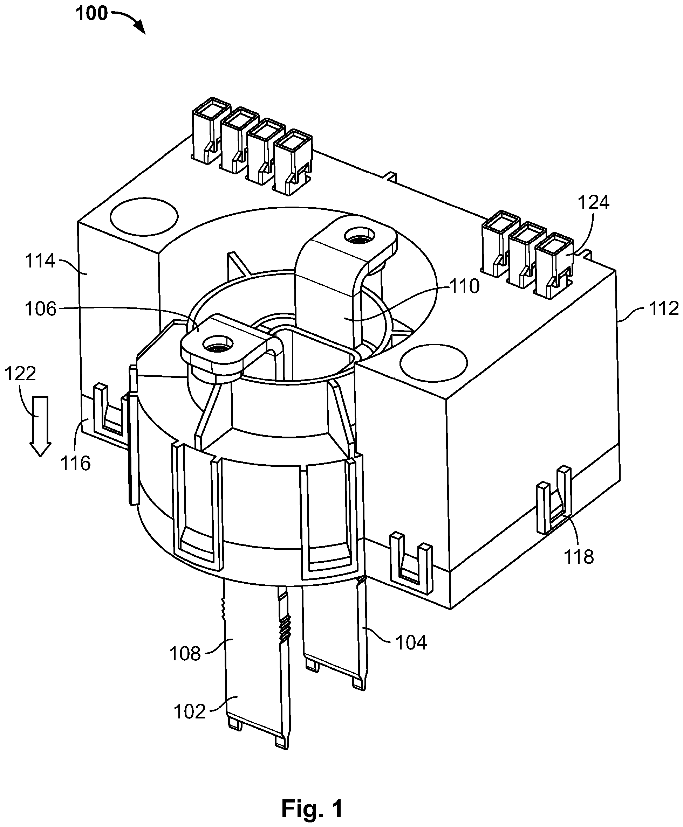

The present invention is explained in greater detail hereafter with reference to the figures, and in particular firstly with reference to Figure 1.

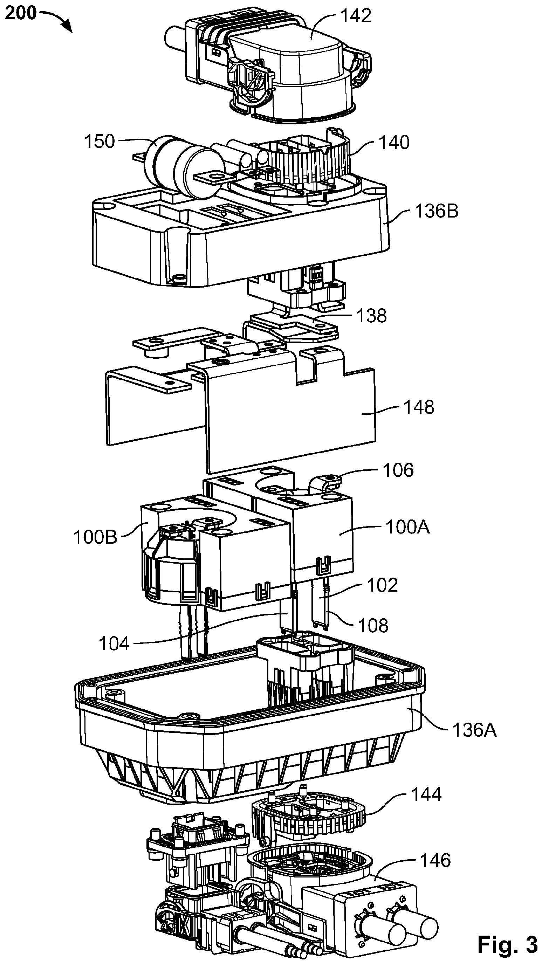

A filter arrangement 100 according to the present invention comprises a first bus bar 102 and a second bus bar 104. Each of the bus bars has a first terminal section 106 and a second terminal section 108, wherein the two terminal sections 106, 108 are connected to one another via a connecting section 110. The first and second terminal sections 106, 108 are respectively connected, as explained in detail with reference to Figure 3, to first and second connector elements.

The filter arrangement 100 has a filter housing 112 which has a housing base body 114 and a housing cover element 116. The two housing elements are fixed to one another via locking connections 118. However, ultrasound welding, a glue connection or another suitable connection technique can obviously also be envisaged.

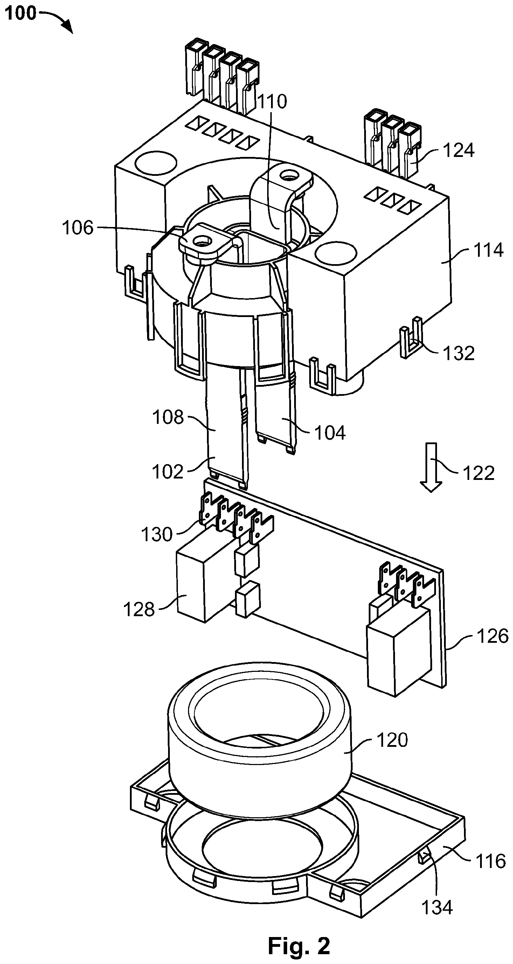

The second terminal sections 108 are designed such that they are used directly as plug contacts in the second connector element. They extend in a straight line out of the connection region 110 and go, as is visible from Figure 2, through a ring core element 120. The first terminal sections 106 are configured as terminal lugs which have screw threads. They are also bent by 90° relative to the connection region 110 in order to enable screwing along a longitudinal direction 122.

The ring core element 120 and a filter circuit are accommodated in the filter housing 112, as can be seen from Figure 2. Terminals 124 are guided outwards in order to contact the filter circuit.

An opened depiction of the filter arrangement 100 from Figure 1 is shown in Figure 2. As can be recognised from this figure, a filter circuit which is arranged on a circuit carrier 126 is provided in the housing base body 114. The filter circuit comprises a plurality of electronic components 128 and electrically conductive terminal lugs 130 which are connected to the terminals 124.

As can be seen in the figures, the circuit carrier 126 of the filter circuit is arranged in the filter housing 112 such that a plane defined by the circuit carrier 126 runs along the longitudinal direction 122. Alternatively (not depicted in the figures), the circuit carrier 126 can run transverse, in particular perpendicular, to the bus bars 102, 104. The circuit carrier 126 is then arranged above or underneath the ring core element 120. Furthermore, it can be envisaged that the circuit carrier 126 is arranged within the opening of the ring core element 120, in particular between the bus bars.

Furthermore, a ring core element 120 is held in the housing such that the bus bars 102, 104 go through it by their connecting sections 110. The filtering and inductive shielding of the bus bars can thus be performed in a particularly space-saving manner.

The ring core element 120 is formed by a torus-shaped ferrite ring, as is generally known. It is furthermore clear to a person skilled in the art that it is also possible to provide several ring core elements 120.

For the interlocking between the housing base body 114 and the housing cover element 116, locking openings 132, which interact with corresponding locking tabs 134 at the housing cover element 116, are provided at the housing base body 114.

The bus bars 102, 104 are held in the housing base body 114 optionally via a press-fit. The bus bars 102, 104 possess good current-carrying capacity and, due to the integrated configuration of plug contacts, have the advantage of reduced losses. The mechanical connections are extraordinarily stable, which means that they also satisfy a motor vehicle's existing high requirements with regard to vibration resistance and temperature resistance.

Due to the design of the filter arrangement 100, any number of such filter modules can be installed in a simple manner in a high-voltage connector arrangement according to the present invention. Figure 3 shows, by way of example, such a high-voltage connector arrangement 200 containing two different filter arrangements 100 A and 100 B. In this case, the filter arrangement 100 A corresponds to the examples shown in Figures 1 and 2, while the filter arrangement 100 B is actually constructed according to the same principles, but has dimensions which are somewhat different.

The high-voltage connector arrangement 200 has a connector housing 136 which is optionally formed by two half shells 136 A, 136 B which are screwed together. The first terminal sections 106 of the filter arrangements 100 A, 100 B are respectively coupled, via corresponding lead frames 138, to a first connector element 140 which can be connected to the battery. Figure 3 depicts the corresponding mating plug connector 142, which is, however, part of the high-voltage connector arrangement 200.

On the load side, two second connector elements 144 are provided which can be connected to corresponding second mating plug connectors 146. In this case, the second terminal sections 108 of the bus bars 102, 104 are respectively designed such that they are part of the second connector elements 144 and directly electrically contact the mating plug connectors 146.

Together with the lead frame 138, there is furthermore provided a shielding 148 which is guided around the two filter arrangements 100 A and 100 B. Furthermore, external components 150 are attached externally to the housing half shell 136 B and are connected to the terminals 124 of the filter arrangements 100 A, 100 B.

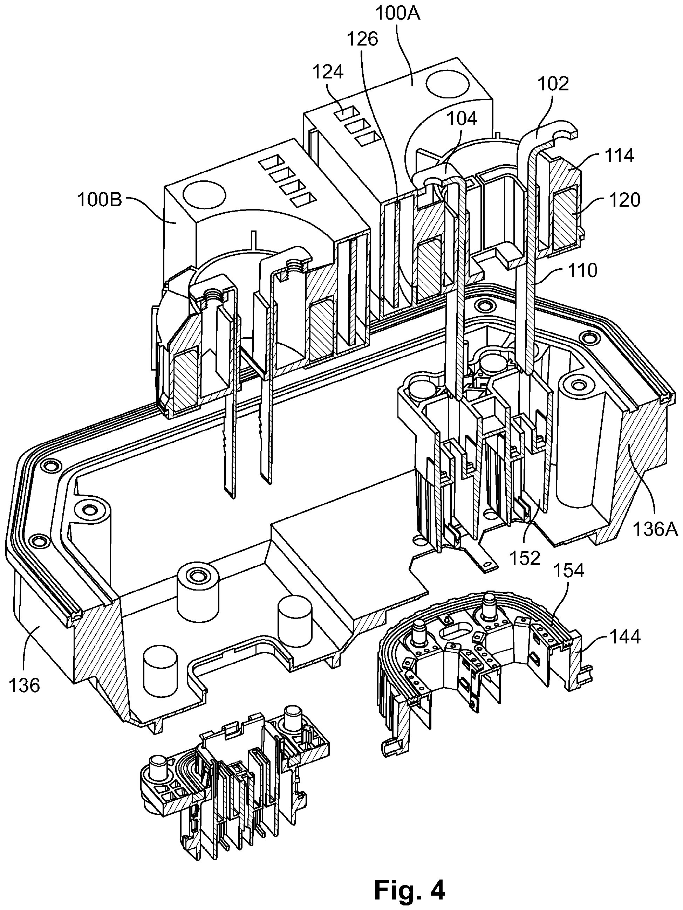

In a partly exploded and sectioned detailed view, Figure 4 shows the first half shell 136 A of the connector housing from Figure 3 with the filter arrangements 100 A and 100 B received therein and the associated second connector elements 144. As can be seen from Figure 4, the bus bars 102, 104 respectively go through ring core elements 120 held in the filter housing. The bus bars are held by their connecting sections 110 respectively in the housing base body 114 by means of a press fit. However, it can also be envisaged that the bus bars 102, 104 are only fixed in the inner insulator 152 of the second connector elements 144.

The second connector elements 144 provide, via sealing elements 154, hermetic sealing of the interior of the housing 136 from the ingress of moisture or dust.

As can furthermore be recognised from the depiction in Figure 4, the circuit carriers 126 are arranged in a particularly space-saving manner, parallel to the extension of the connecting sections 110.

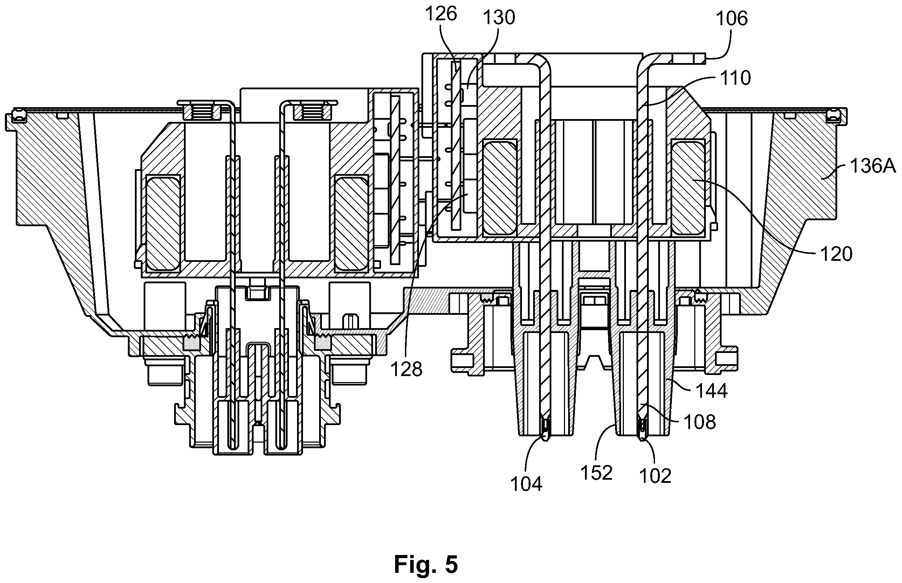

Figure 5 shows the assembled arrangement of Figure 4 in a sectional depiction. As becomes clear once again from this depiction, the second terminal sections 108 of the bus bars directly form the plug contacts of the second connector elements 144 and directly contact the second mating plug connector shown in Figure 3. In an advantageous manner, this integrated design reduces the number of electrical connections and electrically conductive components required. The filtering is also particularly efficient.

**List of reference signs**

| **Reference numeral** | **Description** |
|---|---|
| 100, 100 A, 100 B | Filter arrangement |
| 102 | First bus bar |
| 104 | Second bus bar |
| 106 | First terminal section |
| 108 | Second terminal section |
| 110 | Connecting section |
| 112 | Filter housing |
| 114 | Housing base body |
| 116 | Housing cover element |
| 118 | Locking connection |
| 120 | Ring core element |
| 122 | Longitudinal direction |
| 124 | Terminals of the filter circuit |
| 126 | Circuit carrier |
| 128 | Electronics components of the filter circuit |
| 130 | Terminal lug |
| 132 | Locking opening |
| 134 | Locking tab |
| 136 | Connector housing |
| 138 | Lead frame |
| 140 | First connector element |
| 142 | First mating plug connector |
| 144 | Second connector element |
| 146 | Second mating plug connector |
| 148 | Shielding |
| 150 | External electronic components |
| 152 | Inner insulator |
| 154 | Sealing element |
| 200 | High-voltage connector arrangement |

## Claims

1. A high-voltage connector arrangement (200) with at least one first connector element (140) for contacting a power source and at least one second connector element (144) for contacting a consumer, furthermore comprising at least one filter assembly (100, 100 A, 100 B), wherein each of the at least one first connector element (140) is connected respectively to one of the at least one second connector element (144) by one of the at least one filter assembly (100, 100A, 100B),
each of the at least one filter assembly (100) having:
a first (102) and at least one second (104) electrically conductive bus bar, wherein each bus bar (102, 104) respectively has a first terminal section (106) which is connected to the respective first connector element (140), and a second terminal section (108) which is connected to the respective second connector element (144), and a connecting section (110) which is arranged between the first and second terminal sections (106, 108),
a circuit carrier (126) comprising a filter circuit arranged thereon,
at least one ring core element (120),
a filter housing (112) which encompasses the filter circuit, the ring core element (120), and at least a part of the first and at least one second electrically conductive bus bars (102, 104),
wherein the first and the at least one second bus bars (120, 104) run substantially parallel to each other and go through the at least one ring core element (120), and wherein the circuit carrier (126) is arranged with the filter circuit in a region of the filter housing (112) in which the connecting sections (110) of the bus bars (102, 104) are accommodated, **characterized in that**
the second terminal sections (108) are configured as plug contact elements which are part of the second connector element (144) and which can be connected to associated mating plug contacts,
and wherein terminals (124) are guided outwards on the filter housing (112) to electrically contact the filter circuit.

2. The high-voltage connector arrangement (200) according to Claim 1, wherein the at least one ring core element (120) is produced from a magnetic material.

3. The high-voltage connector arrangement (200) according to Claim 1 or 2, wherein terminal sections (108) which are configured as the plug contact elements emerge as a rectilinear prolongation from the connecting sections (110).

4. The high-voltage connector arrangement (200) according to any one of the preceding claims, wherein the at least one ring core element (120) has the geometry of a torus, the middle axis of which runs along the connecting sections (110) of the bus bars (102, 104).

5. The high-voltage connector arrangement (200) according to any one of the preceding claims, wherein the filter housing (112) has a housing base body (114) in which the bus bars (102, 104) and the circuit carrier (126) are held, and a housing cover element (116) which is fixed to the housing base body (114) in order to close the filter housing (112).

6. The high-voltage connector arrangement (200) according to Claim 5, wherein the housing cover element (116) and the housing base body (114) are interlocked with one another.

7. The high-voltage connector arrangement (200) according to one of the preceding claims, wherein the first terminal section (106) of the at least two bus bars (102, 104) is respectively connected, by means of a screw connection, to one of the at least one first connector element (140), in order to contact the power source.

8. The high-voltage connector arrangement (200) according to one of the preceding claims, wherein the second terminal sections (108) of the at least two bus bars are respectively configured as plug contact elements which are directly part of the second connector element (144).

9. The high-voltage connector arrangement (200) according to one of the preceding claims, furthermore comprising a connector housing (136) in which a plurality of filter assemblies (100, 100 A, 100 B) are held such that the connecting sections (110) of the bus bars (102, 104) run substantially parallel to one another.

10. The high-voltage connector arrangement (200) according to Claim 9, wherein each of the filter assemblies (100, 100 A, 100 B) has a separate filter housing (112).

11. The high-voltage connector arrangement (200) according to Claim 10, furthermore comprising a shielding (148) which is arranged in the connector housing (136) such that said shielding at least partly surrounds the filter assemblies (100, 100 A, 100 B).

12. The high-voltage connector arrangement (200) according to one of the preceding claims, wherein the first and/or the second connector element (140, 144) is designed such that it hermetically seals the at least one filter assembly (100, 100 A, 100 B).

## Patentansprüche

1. Hochspannungssteckverbinderanordnung (200) mit mindestens einem ersten Steckverbinderelement (140) zum Kontakt mit einer Leistungsquelle und mit mindestens einem zweiten Steckverbinderelement (144) zum Kontakt mit einem Verbraucher, ferner mit mindestens einer Filteranordnung (100, 100 A, 100 B), wobei jedes des mindestens einen ersten Steckverbinderelements (140) entsprechend mit einem des mindestens einen zweiten Steckverbinderelements (144) durch eine der mindestens einen Filteranordnung (100, 100 A, 100 B) verbunden ist, wobei jede der mindestens einen Filteranordnung (100) aufweist:
eine erste (102) und mindestens eine zweite (104) elektrisch leitende Stromschiene, wobei jede Stromschiene (102, 104) entsprechend einen ersten Anschlussabschnitt (106), der mit dem entsprechenden ersten Steckverbinderelement (140) verbunden ist, und einen zweiten Anschlussabschnitt (108) aufweist, der mit dem entsprechenden zweiten Steckverbinderelement (144) verbunden ist, und einen Verbindungsabschnitt (110) aufweist, der zwischen dem ersten und dem zweiten Anschlussabschnitt (106, 108) angeordnet ist,
einen Schaltungsträger (126) mit einer Filterschaltung, die daran angebracht ist,
mindestens ein Ringkernelement (120),
ein Filtergehäuse (112), das die Filterschaltung, das Ringkernelement (120) und mindestens einen Teil der ersten und der mindestens einen zweiten elektrisch leitenden Stromschiene (102, 104) aufnimmt,
wobei die erste und die mindestens eine zweite Stromschiene (120, 104) im Wesentlichen parallel zueinander und durch das mindestens eine Ringkernelement (120) verlaufen, und wobei der Schaltungsträger (126) mit der Filterschaltung in einem Gebiet des Filtergehäuses (112) versehen ist, in welchem die Verbindungsabschnitte (110) der Stromschienen (102, 104) aufgenommen sind,
**dadurch gekennzeichnet, dass**
die zweiten Anschlussabschnitte (108) als Steckkontaktelemente ausgebildet sind, die Teil des zweiten Verbinderelements (144) sind und die mit zugehörigen korrespondierenden Steckkontakten verbindbar sind, und
wobei Anschlüsse (124) an dem Filtergehäuse (112) so nach außen geführt sind, dass sie die Filterschaltung elektrisch kontaktieren.

2. Hochspannungssteckverbinderanordnung (200) nach Anspruch 1, wobei das mindestens eine Ringkernelement (120) aus einem Magnetmaterial hergestellt ist.

3. Hochspannungssteckverbinderanordnung (200) nach Anspruch 1 oder 2, wobei die Anschlussabschnitte (108), die als die Steckkontaktelemente ausgebildet sind, als geradlinige Verlängerung aus den Verbindungsabschnitte (110) hervorstehen.

4. Hochspannungssteckverbinderanordnung (200) nach einem der vorhergehenden Ansprüche, wobei das mindestens eine Ringkernelement (120) die Geometrie eines Torus hat, dessen Mittelachse entlang der Verbindungsabschnitte (110) der Stromschienen (102, 104) verläuft.

5. Hochspannungssteckverbinderanordnung (200) nach einem der vorhergehenden Ansprüche, wobei das Filtergehäuse (112) einen Gehäusebasiskörper (114), in welchem die Stromschienen (102, 104) und der Schaltungsträger (126) gehalten werden, und ein Gehäuseabdeckungselement (116) aufweist, das an dem Gehäusebasiskörper (114) befestigt wird, um das Filtergehäuse (112) zu verschließen.

6. Hochspannungssteckverbinderanordnung (200) nach Anspruch 5, wobei das Gehäuseabdeckungselement (116) und der Gehäusebasiskörper (114) aneinander verriegelt sind.

7. Hochspannungssteckverbinderanordnung (200) nach einem der vorhergehenden Ansprüche, wobei der erste Anschlussabschnitt (106) der mindestens zwei Stromschienen (102, 104) mittels einer Schraubverbindung entsprechend mit einem des mindestens einen ersten Verbinderelements (140) verbunden ist, um die Leistungsquelle zu kontaktieren.

8. Hochspannungssteckverbinderanordnung (200) nach einem der vorhergehenden Ansprüche, wobei die zweiten Anschlussabschnitte (108) der mindestens zwei Stromschienen entsprechend als Steckkontaktelemente ausgebildet sind, die unmittelbar Teil des zweiten Steckverbinderelements (144) sind.

9. Hochspannungssteckverbinderanordnung (200) nach einem der vorhergehenden Ansprüche, die ferner ein Verbindergehäuse (136) aufweist, in welchem mehrere Filteranordnungen (100, 100 A, 100 B) so gehalten werden, dass die Verbindungsabschnitte (110) der Stromschienen (102, 104) im Wesentlichen parallel zueinander verlaufen.

10. Hochspannungssteckverbinderanordnung (200) nach Anspruch 9, wobei jede der Filteranordnungen (100, 100 A, 100 B) ein separates Filtergehäuse (112) hat.

11. Hochspannungssteckverbinderanordnung (200) nach Anspruch 10, die ferner eine Abschirmung (148) aufweist, die in dem Verbindergehäuse (136) derart angeordnet ist, dass die Abschirmung zumindest teilweise die Filteranordnungen (100, 100 A, 100 B) umgibt.

12. Hochspannungssteckverbinderanordnung (200) nach einem der vorhergehenden Ansprüche, wobei das erste und/oder das zweite Verbinderelement (140, 144) so gestaltet sind, dass sie die mindestens eine Filteranordnung (100, 100 A, 100 B) hermetisch abdichten.

## Revendications

1. Assemblage de connecteurs haute tension (200) comprenant au moins un premier élément de connecteur (140) destiné à entrer en contact avec une source d'alimentation et au moins un second élément de connecteur (144) destiné à entrer en contact avec un consommateur, comprenant en outre au moins un ensemble filtre (100, 100 A, 100 B), dans lequel chacun dudit au moins un premier élément de connecteur (140) est connecté respectivement à l'un au moins des seconds éléments de connecteur (144) par l'un au moins des ensembles filtres (100 , 100A, 100B) chacun dudit au moins un ensemble filtre (100) comportant:
une première (102) et au moins une seconde (104) barres omnibus conductrices d'électricité, dans lesquelles chaque barre omnibus (102, 104) présente respectivement une première section de borne (106) qui est connecté à l'élément de connecteur respectif (140), et à une seconde section de borne (108) qui est connectée au second élément de connecteur respectif (144), et à une section de connexion (110) qui est agencée entre les première et seconde sections de borne (106, 108),
un support de circuit (126) comprenant un circuit de filtrage agencé sur celui-ci,
au moins un élément central annulaire (120),
un boîtier de filtre (112) qui englobe le circuit de filtre, l'élément central annulaire (120) et au moins une partie de la première barre omnibus et au moins une seconde barre omnibus électriquement conductrice (102, 104),
dans lequel la première barre omnibus et au moins une seconde barre omnibus (120, 104) s'étendent sensiblement parallèlement l'une à l'autre et traversent ledit au moins un élément central annulaire (120), et dans lequel le support de circuit (126) est agencé avec le circuit de filtrage dans une zone du boîtier de filtre (112) dans laquelle sont logées les sections de connexion (110) des barres omnibus (102, 104), **caractérisé en ce que**
les secondes parties de borne (108) sont configurées comme éléments de contact à fiche qui font partie du second élément de connecteur (144) et qui peuvent être connecté aux contacts à fiche correspondants,
et dans lequel les bornes (124) sont guidées vers l'extérieur sur le boîtier de filtre (112) pour venir au contact électrique du circuit de filtre.

2. Assemblage de connecteurs haute tension (200) selon la revendication 1, dans lequel ledit au moins un élément central annulaire (120) est fabriqué à partir d'un matériau magnétique.

3. Assemblage de connecteurs haute tension (200) selon les revendications 1 ou 2, dans lequel les sections de borne (108) qui sont configurées comme éléments de contact à fiche sous forme de prolongement rectiligne à partir des sections de connexion (110).

4. Assemblage de connecteurs haute tension (200) selon l'une quelconque des revendications précédentes, dans lequel ledit au moins un élément central annulaire (120) présente la forme géométrique d'un tore, dont l'axe médian longe les sections de connexion (110) des barres omnibus (102,104).

5. Assemblage de connecteurs haute tension (200) selon l'une quelconque des revendications précédentes, dans lequel le boîtier de filtre (112) comporte un corps de base de boîtier (114) dans lequel les barres omnibus (102, 104) et le support de circuit (126) sont maintenus et un élément de couvercle de boîtier (116) qui est fixé au corps de base de boîtier (114) afin de fermer le boîtier de filtre (112).

6. Assemblage de connecteurs haute tension (200) selon la revendication 5, dans lequel l'élément de couvercle de boîtier (116) et le corps de base de boîtier (114) sont imbriqués l'un dans l'autre.

7. Assemblage de connecteurs haute tension (200) selon l'une des revendications précédentes, dans lequel la première section de borne (106) d'au moins deux barres omnibus (102, 104) est respectivement connectée, au moyen d'une connexion à vis, à l'un au moins des premiers éléments de connecteur (140),
afin de se brancher sur la source d'alimentation.

8. Assemblage de connecteurs haute tension (200) selon l'une des revendications précédentes, dans lequel les secondes sections de bornes (108) desdites au moins deux barres omnibus sont respectivement configurées comme éléments de contact à fiche qui font directement partie du second élément de connecteur (144).

9. Assemblage de connecteurs haute tension (200) selon l'une des revendications précédentes, comprenant en outre un boîtier de connecteur (136) dans lequel une pluralité d'ensembles de filtres (100, 100 A, 100 B) sont maintenus de telle sorte que les sections de connexion (110) des barres omnibus (102, 104) sont sensiblement parallèles les unes aux autres.

10. Assemblage de connecteurs haute tension (200) selon la revendication 9, dans lequel chacun des ensembles de filtres (100, 100 A, 100 B) comporte un boîtier de filtre séparé (112).

11. Assemblage de connecteurs haute tension (200) selon la revendication 10, comprenant en outre un blindage (148) qui est agencé dans le boîtier de connecteur (136) de sorte que ledit blindage entoure au moins partiellement les ensembles de filtres (100, 100A, 100 B).

12. Assemblage de connecteurs haute tension (200) selon l'une des revendications précédentes, dans lequel le premier et/ou le second élément de connecteur (140, 144) est conçu de manière à sceller hermétiquement ledit au moins un ensemble de filtre (100, 100A, 100B).
